# EUROPÄISCHE PATENTSCHRIFT

(11) **EP 0 980 528 B1**
(45) Veröffentlichungstag und Bekanntmachung des Hinweises auf die Patenterteilung: **31.10.2001**
(21) Anmeldenummer: 98913646.0
(22) Anmeldetag: 05.03.1998
(51) Int. Cl.: G01R 15/04

(54) **SPANNUNGSSENSOR FÜR MESS- UND SCHUTZZWECKE FÜR MITTELSPANNUNGSSCHALTANLAGEN**
VOLTAGE DETECTOR FOR MEASUREMENT AND PROTECTION PURPOSES FOR USE IN MEDIUM-VOLTAGE SWITCH GEAR
DETECTEUR DE TENSION S'UTILISANT A DES FINS DE MESURE ET DE PROTECTION POUR DES INSTALLATIONS DE DISTRIBUTION MOYENNE TENSION

(30) Priorität: 09.05.1997 DE 19719521
(43) Veröffentlichungstag der Anmeldung: 23.02.2000
(73) Patentinhaber: Felten & Guilleaume AG, 51063 Köln (DE)
(72) Erfinder: DIRKS, Rolf, D-47877 Willich (DE)
(86) Internationale Anmeldenummer: EP9801244
(87) Internationale Veröffentlichungsnummer: WO9852053

(56) Entgegenhaltungen:
- EP-A- 0 678 956
- DE-A- 2 841 466
- DE-A- 4 107 944
- FR-A- 2 506 947
- US-A- 4 241 373

## Beschreibung

Die Erfindung betrifft einen Spannungssensor mit einem ohmschen Spannungsteiler für Mittelspannungsschaltanlagen, insbesondere zur Anordnung an einem Kabelwinkelstecker.

Spannungssensoren gehören zur Sekundärtechnik in Mittelspannungsschaltanlagen und sind für deren Betriebsführung, insbesondere hinsichtlich einer erhöhten Personen- und Betriebssicherheit, der Minimierung von Funktionseinheiten und Baugruppen und der Reduzierung des Prüfaufwandes von großer Bedeutung.

Es ist bekannt, ohmsche Spannungsteiler als Spannungssensoren zur Messung und Prüfung von Gleich- und Wechselspannungen auszubilden und mit diesen eine zu einer Primärspannung proportional verringerte Ausgangsspannung zu erzeugen und zu messen.

So ist aus dem Katalog "Current and Voltage Sensors" der Firma ABB Strömberg Distribution Ltd., Fin-65101 Vaasar, Finnland, ein als Spannungssensor ausgebildeter Spannungsteiler bekannt, der zur Messung von Spannungen an SF₆- und luftisolierten Schaltanlagen bestimmt und als externe Funktionseinheit ausgebildet ist.

Aus dem Aufsatz "Schaltanlagentechnik für die Zukunft" in der Zeitschrift etz, (1993) Band 114, S. 1000-1003, ist ein Spannungssensor mit einem ohmschen Präzisionsspannungsteiler für Schaltanlagensysteme bekannt, der - ebenfalls als externe Funktionseinheit - parallel zu einem Kabelanschluß anordbar ist.

In dem Aufsatz "Neue Schaltanlagentechnik" in der Zeitschrift etz, (1996), Heft 7, S, 6-10, ist eine Schaltanlage beschrieben, die aus metallgekapselten, gasisolierten Schaltfeldern aufgebaut ist, die jeweils einen kombinierten Strom- und Spannungssensor mit einem kapazitiven Abgriff aufweisen. Als Spannungssensor dient ein ohmscher Spannungsteiler. Der kombinierte Sensor enthält eine Elektrodenanordnung zur Abschirmung des Spannungsteilers, die gleichzeitig als kapazitiver Abgriff genutzt wird.

Gegenstand der DE 296 05 845 U1 ist ein Sensor zur Strom- und Spannungsmessung für Mittelspannungsschaltanlagen, der als Kombinationsgerät ausgebildet ist, bei dem für die Spannungsmessung ein ohmscher Spannungsteiler verwendet wird. In einer Ausführungsform sind die kombinierten Sensoranordnungen in einem Block aus Gießharz eingegossen.

In einer weiteren Schrift (DE 28 41 466 A1) findet sich ein Hochspannungsteiler, der in einem Porzellanüberwurf angeordnet ist.

Aus der Druckschrift DE 41 22 331 A1 ist eine Sensoranordnung zur Strom- und Spannungsmessung bekannt, die in einem Block aus Gießharz eingegossen und als Kombi-Gerät gestaltet ist. Der in diesem angeordnete ohmsche Spannungsteiler besteht aus einem Widerstandsstreifen, dessen beide Enden von topfförmigen Feldsteuerelektroden für einen gleichmäßigen Feldverlauf umgeben sind, wobei die Feldsteuerelektroden im Innern des Blockes angeordnet, also mit eingegossen sind. Eine leitfähige Beschichtung weist der Block nicht auf. Überdies ist er für eine Anordnung in einem Kabelsteckteil nicht geeignet.

Die vorbeschriebenen Spannungssensoren sind jeweils für einen bestimmten Mittelspannungsbereich ausgelegt und zum Teil in montagetechnischer und handhabungstechnischer Hinsicht aufwendig.

In der EP 0 678 956 A1 ist ein Strom- und Spannungssensor in einem Gießharzgehäuse beschrieben. Als Spannungssensor ist ein langgestreckter hochohmiger Widerstand vorgesehen. Als Stromsensor ist eine Rogowski-Spule um den Strompfad herum angebracht. Der Sensor wird in die Wand eines Hochspannungsschaltfeldes eingebaut und hat je ein von außen zugängliches Durchgangsstück zum Abgriff der Spannung und des Stroms für eine Signal- oder Datenverarbeitungsanlage. Ais Kabelsteckteil ist dieser Sensor nicht einsetzbar.

Ein kapazitiver Spannungssensor für eine Schaltanlage mit Vakuumschalter wird in der US 4.241.373 vorgeschlagen. Der Spannungssensor ist im Epoxid-Gehäuse des Vakuumschalters an der Stelle einer von zwei Anschlußbuchsen für ein Steckteil integriert. Das Gehäuse des Vakuumschalters ist bis auf die Anschlußbuchsen mit einer Leitschicht versehen, wobei die Leitschicht über einen Flansch zu einem tragenden Gehäuse geerdet ist. Durch die Integration des kapazitiven Sensors in das Schaltergehäuse ist ein bestimmter Spannungsbereich festgelegt. Der Sensoraufbau eignet sich nicht für die Verwendung in variablen Spannungsbereichen.

Es ist Aufgabe der Erfindung, einen Spannungssensor für Meß- und Schutzzwecke nach dem Oberbegriff des Anspruchs 1 zu schaffen, der in unterschiedlichen Mittelspannungsbereichen verwendbar, kompakt gestaltet und auf einfache Weise montierbar ist.

Diese Aufgabe wird bei einem gattungsgemäßen Spannungssensor nach dem kennzeichnenden Teil des Anspruchs 1 gelöst. Vorteilhafte Ausgestaltungen finden sich in den Unteransprüchen.

Mit diesem Gegenstand wird ein sehr kompakter Spannungssensor zur lösbaren Anordnung in einem Kabelsteckteil geschaffen, insbesondere auch im Hinblick auf den erhebliche räumliche Abmessungen aufweisenden Hochspannungswiderstand, der auf einfache Weise, vorzugsweise durch Einschraubung montierbar ist.

Der aus einem in Gießharz eingegossene ohmsche Spannungsteiler und einem Erdungsanschluß gebildete Spannungssensor ist vorzugsweise derart gestaltet, daß der Spannungsteiler aus einem hochohmigen Hochspannungswiderstand, vorzugsweise aus Keramik, und mehreren mit diesem in Reihe geschalteten Niederspannungsteilerwiderständen besteht, wobei sämtliche Widerstände ausgangsseitig mit jeweils einem an der Außenseite des Spannungssensors angeordneten elektrischen Kontaktelement verbunden sind. Durch Verwendung mehrerer Niederspannungsteilerwiderstände, kann der Meßbereich des Sensors auf verschiedene Spannungsebenen (beispielsweise 10 kV, 15 kV oder 20 kV) umgestellt werden. Da der Hochspannungswiderstand wesentliche räumliche Abmessungen besitzt, treten Streukapazitäten auf, die bei der Messung steiler Hochspannungsimpulse zu erheblichen Meßfehlern führen können. Es ist daher vorgesehen, den Teilerwiderständen Bauelemente zur Begrenzung der Streukapazitäten zuzuordnen. Eine Maßnahme kann sein, Schutzwiderstände hinzuzuschalten. Es wird weiterhin vorgeschlagen, die Streukapazitäten durch eine umfangsseitig wenigstens in dem aus dem Kabelsteckteil ragenden Bereich leitfähige und geerdete Beschichtung des als Verschlußstopfen ausgebildeten Gießkarzkörpers zu begrenzen.

Die Kontaktelemente und/oder der Erdungsanschluß, die vorteilhafterweise als Steck- oder Gewindebuchsen für den Anschluß eines Meß- oder Prüfgerätes ausgeführt sind, erlauben somit jeweils einen Teilspannungsabgriff. Parallel zu den Niederspannungsteilerwiderständen ist ein Überspannungsableiter angeordnet und mit dem Erdungsanschluß verbunden.

Dieser kompakt ausgeführte Spannungssensor ist einfach handhabbar und auf Grund der Anordnung mehrerer Niederspannungsteilerwiderstände im Spannungsteiler zur Messung und Prüfung mehrerer Bereiche von Mittelspannungen bei gleicher Ausführungsform einsetzbar. Dabei ist der in Gießharz ausgeführte Spannungssensor im wesentlichen wartungsfrei, nicht störanfällig und kompakt.

Der Überspannungsableiter kann als gasgefüllter Überspannungsableiter ausgeführt sein. Diese Überspannungsableiter haben ein höheres Ableitungsverhalten als elektronische Spannungsbegrenzer (Zenerdioden).

Der Spannungsteiler ist im Verschlußstopfen eines Kabelsteckteils integriert und ist damit für jeden Meßvorgang unmittelbar verfügbar. Der Verschlußstopfen ist umfangsseitig in dem aus dem Kabelsteckteil ragenden Bereich mit einer leitfähigen Beschichtung versehen und bildet gemeinsam mit dem leitfähigen Belag des Kabelsteckteils über den Massekontakt mit dem Metallgehäuse des Kabelsteckteils eine Feldsteuerung für den Hochspannungswiderstand. Die Beschichtung kann eine Leitlackschicht sein, die einfach auftragbar ist.

Die Erfindung wird nachstehend an einem Ausführungsbeispiel erläutert. Die zugehörigen Figuren zeigen teilweise schematisch und geschnitten im Einzelnen:
- Fig. 1:: einen Längsschnitt durch einen als Verschlußstopfen für ein Kabelsteckteil ausgebildeten Spannungssensor,
- Fig. 2:: eine Draufsicht auf die rückwärtige Stirnseite des Verschlußstopfens und
- Fig. 3: das Schaltbild des Spannungssensors.

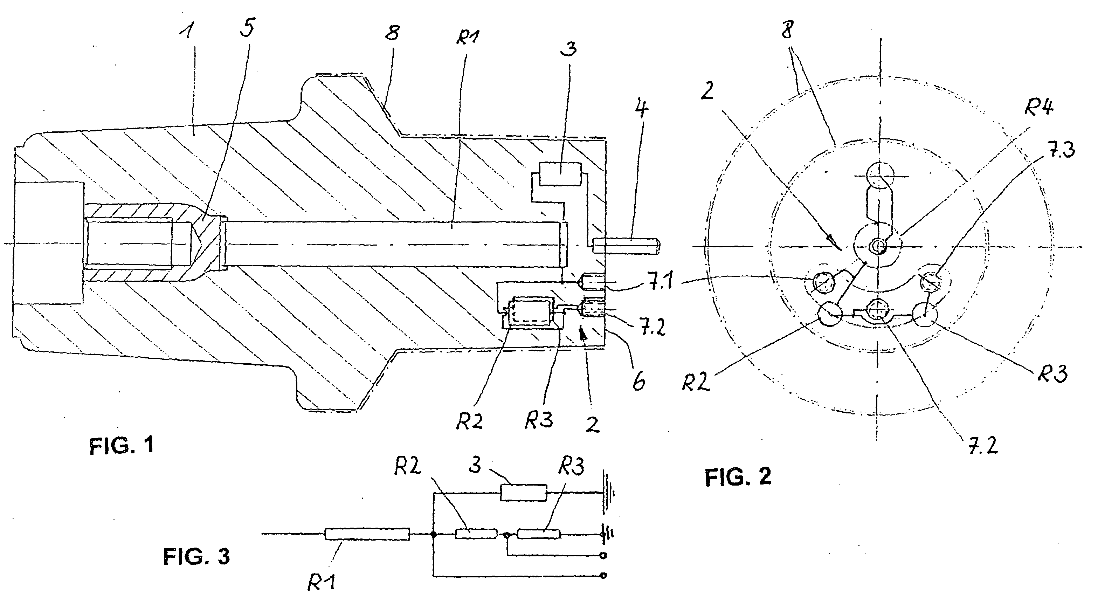

Fig. 1 zeigt einen als Spannungssensor ausgebildeten Verschlußstopfen 1 in Anlehnung an DIN 47636 (400 A; Konus) eines Kabelsteckteils mit einem integrierten ohmschen Spannungsteiler 2 und einem mit diesem verbundenen gasgefüllten Überspannungsableiter 3 und einem Erdungsanschluß 4. Solche Kabelsteckteile haben ein (in der Regel aus zwei Hälften bestehendes) Metallgehäuse, über welches auch der Masseanschluß erfolgt. Der Spannungsteiler 2 ist aus einem hochohmigen Hochspannungswiderstand R1 (100 MOhm) aus Keramik und zwei mit diesem in Reihe geschalteten Niederspannungsteilerwiderständen R2 und R3 (jeweils 1 kOhm) gebildet. Kabelseitig ist der Hochspannungswiderstand R1 mit einer Kontaktschraube 5 elektrisch kontaktiert, die am Kabelschuh eines mittels einer Kontaktschraube am Kontaktstück eines Durchführungsisolators fixierten Kabels elektrisch verbunden ist (nicht dargestellt). Zwischen den Widerständen R1 und R2 sowie R2 und R3 ist jeweils ein Spannungsabgriff angeordnet, der mit einer an der Stirnseite 6 des Verschlußstopfens 1 angeordneten Anschlußbuchse 7.1 bzw. 7.2 verbunden ist. Ebenso ist der Niederspannungswiderstand R3 ausgangsseitig mit einer Anschlußbuchse 7.3 verbunden, bzw. hat über die Erdverbindung Kontakt mit Masse.

Fig. 2 zeigt, daß drei Anschlußbuchsen 7.1 bis 7.3 vorhanden sind, die im radialen Abstand vom Erdungsanschluß 4 und im Abstand voneinander angeordnet sind. An diesen Anschlußbuchsen (7.1, 7.2) können auf Grund der Anordnung der Niederspannungsteilerwiderstände R2 und R3 zwei verschiedene Teilspannungen abgegriffen werden. Das Schaltbild dazu ist in Fig. 3 dargestellt.

Der Verschlußstopfen 1 ist umfangsseitig in dem Bereich, der aus dem (nicht dargestellten) Kabelsteckteil herausragt, mit einer Beschichtung 8 aus Leitlack versehen, die in Ergänzung und gemeinsam mit dem äußeren leitfähigen Belag des Kabelsteckteils eine Feldsteuerung für den Hochspannungswiderstand R 1 bildet.

## Patentansprüche

1. Spannungssensor für Meß- und Schutzzwecke für Mittelspannungsschaltanlagen mit einem in Gießharz eingegossenen ohmschen Spannungsteiler (2) mit einem Hochspannungswiderstand (R1) sowie einem Erdungsanschluß, **dadurch gekennzeichnet, daß** der Spannungsteiler (2) mehrere mit dem Hochspannungswiderstand (R1) in Reihe geschaltete Niederspannungswiderstände (R2; R3) aufweist und mit einem parallel zu diesen geschalteten Überspannungsableiter (3) versehen ist, und daß der durch das Gießharz gebildete Körper als Verschlußstopfen (1) zur lösbaren Anordnung in einem Kabelsteckteil ausgebildet ist, an des Verschlußstopfens (1) kabelseitiger Stirnseite ein mit dem Hochspannungswiderstand (R1) verbundenes Kontaktelement (5) für ein im Kabelsteckteil angeordnetes und mit dem in diesem fixierten Kabel verbundenes Kontaktglied eingebettet ist und an dem dem Kabelsteckteil abgewandten Endbereich des Verschlußstopfens Kontaktelemente (7.1, 7.2, 7.3) für jeweils nach den Widerständen (R1; R2; R3) angeordnete Spannungsabgriffe und der Erdungsanschluß (4) eingebettet sind, und daß der Verschlußstopfen (1) umfangsseitig wenigstens in dem aus dem Kabelsteckteil ragenden Bereich mit einer geerdeten leitfähigen Beschichtung (8) versehen ist.

2. Spannungssensor nach Anspruch 1, **dadurch gekennzeichnet, daß** die Kontaktelemente (7.1, 7.2, 7.3) und der Erdungsanschluß (4) an der dem Kabelsteckteil abgewandten Stirnseite des Verschlußstopfens (1) angeordnet sind.

3. Spannungssensor nach Anspruch 1 oder 2, **dadurch gekennzeichnet, daß** der Überspannungsableiter (3) ein gasgefüllter Überspannungsableiter ist.

4. Spannungssensor nach Anspruch 1, **dadurch gekennzeichnet, daß** die Beschichtung (8) ein Leitlack ist.

5. Spannungssensor nach Anspruch 1, **dadurch gekennzeichnet, daß** der Hochspannungswiderstand (R1) ein Keramikwiderstand ist.

6. Spannungssensor nach einem der vorhergehenden Ansprüche, **dadurch gekennzeichnet, daß** die Kontaktelemente (7.1, 7.2, 7.3) und/oder der Erdungsanschluß (4) als Steck- oder Gewindebuchsen ausgeführt sind.

## Claims

1. A voltage sensor for measurement and protection purposes for medium-voltage switchgear, having a resistance voltage divider (2) sealed in cast resin and with a high-voltage resistor **(R1)** and an earthing connexion, **characterized in that** the voltage divider (2) has a plurality of low-voltage resistors **(R2; R3)** connected in series with the high-voltage resistor **(R1)** and is provided with an overvoltage arrester (3) connected in parallel to the low-voltage resistors **(R2; R3),** and that the body formed by the cast resin is constructed in the form of a closure plug (1) to be arranged in a releasable manner in a cable connector part, a contact member (5) connected to the high-voltage resistor **(R1)** for a contact member arranged in the cable connector part and connected thereto in this fixed cable is embedded in the end face of the closure plug (1), and contact members (7.1, 7.2, 7.3) for voltage taps arranged respectively downstream of the resistors (**R1; R2; R3**) and the earthing connexion (4) are embedded in the end region of the closure plug remote from the cable connector part, and that the closure plug (1) is provided on the periphery thereof with an earthed conductive coating (8) at least in the region projecting out of the cable connector part

2. A voltage sensor according to Claim 1, **characterized in that** the contact members (7.1, 7.2, 7.3) and the earthing connexion (4) are arranged on the end face of the closure plug (1) remote from the cable connector part.

3. A voltage sensor according to Claim 1 or 2, **characterized in that** the overvoltage arrester (3) is a gas-filled overvoltage arrester.

4. A voltage sensor according to Claim 1, **characterized in that** the coating (8) is a conductive lacquer.

5. A voltage sensor according to Claim 1, **characterized in that** the high-voltage resistor **(R1)** is a ceramic resistor.

6. A voltage sensor according to one of the preceding Claims, **characterized in that** the contact members (7.1, 7.2, 7.3) and/or the earthing connexion (4) is or are constructed in the form of plug-in sockets or screw sockets.

## Revendications

1. Capteur de tension s'utilisant à des fins de mesure et de protection pour des installations de distribution de moyenne tension, comportant un diviseur ohmique (2), enrobé dans de la résine de coulée, qui comporte une résistance de haute tension (R1) ainsi qu'une sortie de mise à la terre, **caractérisé en ce que** le diviseur de tension (2) comporte plusieurs résistances de basse tension (R2 ; R3) montées en série avec la résistance de haute tension (R1) et est doté d'un circuit de protection contre les surtensions (3) monté en parallèle avec celles-ci, et **en ce que** le corps formé par de la résine de coulée se présente sous la forme d'un bouchon de fermeture (1) pour être agencé de façon amovible dans une pièce de connexion de câble, la face du bouchon de fermeture (1) côté câble incorporant un élément de contact (5) relié à la résistance de haute tension (R1) pour un élément de contact agencé dans la pièce de connexion de câble et relié au câble fixé dans celle-ci, la région d'extrémité du bouchon de fermeture opposée à la pièce de connexion de câble incorporant la sortie de mise à la terre (4) et des éléments de contact (7.1, 7.2, 7.3) pour des prises de tension correspondantes agencées après les résistances (R1 ; R2 ; R3), et **en ce que** le bouchon de fermeture (1) est doté du côté périphérique, au moins dans la région faisant saillie de la pièce de connexion de câble, d'une couche de revêtement (8) conductrice et mise à la terre.

2. Capteur de tension selon la revendication 1, **caractérisé en ce que** les éléments de contact (7.1, 7.2, 7.3) et la sortie de mise à la terre (4) sont agencés sur la face du bouchon de fermeture (1) opposée à la pièce de connexion de câble.

3. Capteur de tension selon la revendication 1 ou 2, **caractérisé en ce que** le circuit de protection contre les surtensions (3) est un circuit de protection contre les surtensions qui est rempli d'un gaz.

4. Capteur de tension selon la revendication 1, **caractérisé en ce que** la couche de revêtement (8) est une laque conductrice.

5. Capteur de tension selon la revendication 1, **caractérisé en ce que** la résistance de haute tension (R1) est un résistance en céramique.

6. Capteur de tension selon l'une des revendications précédentes, **caractérisé en ce que** les éléments de contact (7.1, 7.2, 7.3) et/ou la sortie de mise à la terre se présentent sous la forme d'une fiche femelle ou d'une douille taraudée.
